# EUROPEAN PATENT APPLICATION

(11) **EP 4 675 226 A1**
(43) Date of publication of application: **07.01.2026**
(21) Application number: 24185591.5
(22) Date of filing: 01.07.2024
(51) Int. Cl.: G01C 19/574

(54) **A MEMS DEVICE**

(71) Applicant: Murata Manufacturing Co., Ltd., Nagaokakyo-shi, Kyoto 617-8555 (JP)
(72) Inventor: KAAJAKARI, Ville, 00350 Helsinki (FI)
(74) Representative: Boco IP Oy Ab

(57) **Abstract**

A microelectromechanical device which comprises a first proof mass and a second proof mass. A first coupling structure is configured to transmit force in a primary direction between the first and second proof masses. The first coupling structure is connected to a primary spring structure in a first suspension structure which extends from a first anchor point to the first proof mass. The first primary spring structure is more flexible in the primary direction than in the y-direction.

## Description

### FIELD OF THE DISCLOSURE

This disclosure relates to microelectromechanical (MEMS) devices, and more particularly to devices where two proof masses are coupled to each other. The disclosure further concerns devices where proof masses need to move in two mutually perpendicular directions.

### BACKGROUND OF THE DISCLOSURE

MEMS devices such as gyroscopes are used widely in automotive stability control, navigation, and consumer electronics. Gyroscopes measure angular rotation. A common challenge in gyroscope design is that single-mass gyroscopes are also sensitive to acceleration. If a single-mass gyroscope undergoes linear acceleration, the measurement signal generated by the accelerating mass may be erroneously interpreted as an angular rotation signal. If a single-mass gyroscope experiences acceleration and angular rotation simultaneously, the acceleration-generated signal will often be large enough to mask the true angular rotation signal generated by the (relatively weak) Coriolis force.

To suppress the acceleration-generated signal, many MEMS gyroscopes use mass pairs that are driven to oscillate out-of-phase (in opposite directions). This arrangement can be used to generate a differential angular rotation signal which can be reliably separated from acceleration-induced signal, since acceleration always moves all masses in the same direction (in-phase motion).

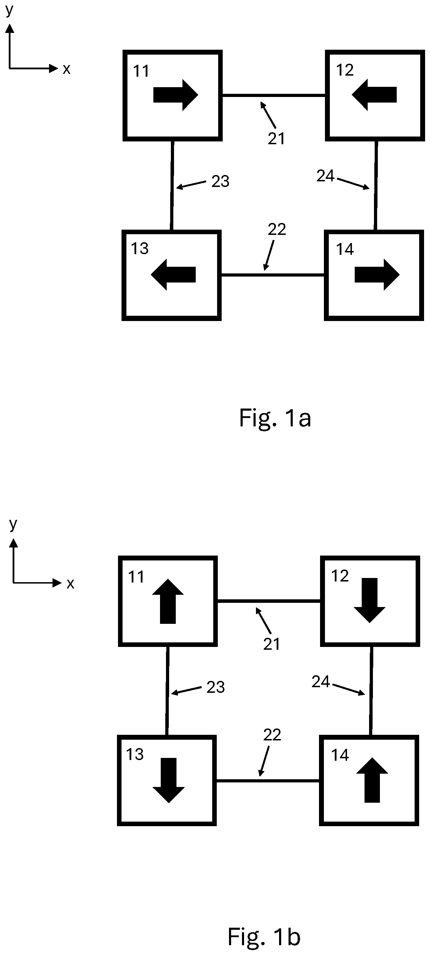

Two- and four-mass designs with two orthogonal oscillation modes are often an attractive option. As a non-limiting example, figure 1a illustrates schematically a four-mass device. Figure 1a shows an oscillation mode where two pairs of masses (11+12 and 13+14) move out-of-phase in the x-direction. The black arrows indicate mass movement in one phase of the oscillation cycle. In the opposite phase (which is not illustrated), masses 11+12 will move away from each other and masses 13 and 14 move toward each other in the x-direction. Figure 1b illustrates another oscillation mode in the same gyroscope where mass pairs 11+13 and 12+14 move out-of-phase in the y-direction. In the opposite phase of this oscillation cycle, the direction is again reversed.

If the device is a gyroscope, one of the two oscillation modes (the primary oscillation mode) must continuously be driven by internal force transducers, while the other oscillation mode (the secondary oscillation mode) is generated by the Coriolis force when the gyroscope undergoes rotation. The primary oscillation typically has a much larger amplitude than the secondary oscillation. Assuming that figure 1a illustrates the primary oscillation mode and figure 1b the secondary oscillation mode, each mass 11 - 14 may be connected to a force transducer which drives the mass back and forth in primary oscillation, as figure 1a illustrates.

The masses in each mass pair in figure 1a are coupled to each other with coupling structures 21 - 24 which synchronize the illustrated out-of-phase motion but resist in-phase motion where both masses in a pair would move in the same direction. The two oscillation modes should occur independently of each other. The coupling structure 21 between masses 11 and 12, for example, should preferably transfer force only in the x-direction, not in the y-direction. This ensures that the primary oscillation is not registered as an angular rotation signal.

The same general considerations apply if the primary oscillation is in the z-direction and the secondary oscillation is in the y-direction. The coupling structure should then transfer force effectively in the z-direction (perpendicular to the xy-plane), but not transfer force in the y-direction.

Consequently, coupling structures in MEMS devices often have to meet two requirements which are not easy to achieve. The first requirement is that out-of-phase force transfer in a first oscillation mode should be powerful. The corresponding in-phase movement, where the coupled masses both move in the same direction, should be stiffly resisted.

The second requirement is that the transferred forces should be carefully directed only in the intended direction. Cross-axis motion, where (for example) primary oscillation in the x-direction also shifts the masses slightly in the y-direction due to the influence of the coupling structure, should be eliminated or at least minimized. This will ensure that any movement measured in a second oscillation mode (the y-direction) will (in the case of a gyroscope) be a result of the Coriolis force - not an unintended cross-axis artefact.

Other requirements, such as minimizing the space that a coupling structure consumes, may also have to be taken into account when the coupling structure is designed.

### BRIEF DESCRIPTION OF THE DISCLOSURE

An object of the present disclosure is to provide a MEMS device with an efficient coupling structure. The object of the disclosure is achieved by an arrangement which is characterized by what is stated in the independent claim. The preferred embodiments of the disclosure are disclosed in the dependent claims.

### BRIEF DESCRIPTION OF THE DRAWINGS

In the following the disclosure will be described in greater detail by means of preferred embodiments with reference to the accompanying drawings, in which:
Figures 1a - 1b illustrate a device with a four-mass design.
Figure 2a illustrates suspension arrangements around a first proof mass.
Figures 2b - 2g illustrate suspension and coupling arrangements between a first and a second proof mass.
Figures 3a - 3b illustrate force transducer arrangements.
Figures 4a - 4d illustrate practical example designs in an in-plane embodiment.
Figure 5 illustrates coupling in two mutually perpendicular in-plane directions.
Figures 6a - 6c illustrate practical example designs in an out-of-plane embodiment.
Figure 7 illustrates coupling in two mutually perpendicular directions, one of which is an in-plane direction, the other an out-of-plane direction.

### DETAILED DESCRIPTION OF THE DISCLOSURE

The device described in this disclosure may be a gyroscope. Alternatively, the device may be a resonator. The arrangement described in this disclosure can be used also in other MEMS devices where two mutually perpendicular oscillation modes are needed.

The proof masses described in this disclosure may be connected to force transducers, which may be called drive transducers, which are configured to set the proof masses into a first oscillation mode. The first oscillation mode may be induced by applying a drive signal to one or more drive transducers. If the device is a gyroscope, the first oscillation mode may be called the primary oscillation mode. The proof masses may also be connected to force transducers which measure the movement they undergo in a second oscillation mode. These force transducers may be called sense transducers, and they may be configured to generate a sense signal, which in the case of gyroscopes may be called an angular rotation signal. At any given moment, the amplitude of the sense signal may be proportional to the momentary angular rotation experienced by the gyroscope.

The proof masses may be formed in a device layer, which may for example be a wafer, or a layer which has been deposited on a surface. The device layer may be made of silicon. The device layer may define a device plane, which is illustrated as the xy-plane in the figures of this disclosure.

Each proof mass may be suspended from an adjacent fixed structure by an at least partly flexible suspension structure which allows the proof mass to move in relation to the fixed structure. The term "proof mass" refers in this disclosure to a body which is substantially rigid (at least in comparison to its suspension structure). Each proof mass may move as a single body in primary and secondary oscillation, but a pair of proof masses which are coupled to each other with a coupling structure may move in opposite directions.

The device layer may define a device plane, which is illustrated as the x-y plane in the figures of this disclosure. The coupling structure described in this disclosure may be configured to synchronize the movement of a proof mass pair in the device plane.

Two mutually perpendicular oscillation modes are discussed in this disclosure. The first oscillation mode may comprise proof mass movement in the direction of an x-axis, and the second oscillation mode may comprise proof mass movement in the direction of a y-axis. This will be called the in-plane embodiment.

Alternatively, the first oscillation mode may comprise proof mass movement in the direction of a z-axis which is perpendicular to both the x-axis and the y-axis, and the second oscillation mode may comprise proof mass movement in the direction of the y-axis. This will be called the out-of-plane embodiment.

In any embodiment presented in this disclosure, if the device is a gyroscope, the first oscillation mode may be the primary oscillation mode of the gyroscope and the second oscillation mode may be the secondary oscillation mode of the gyroscope.

This disclosure describes a microelectromechanical device which comprises a first proof mass and a second proof mass in a device plane. The device plane is defined by an x-axis and a y-axis which is perpendicular to the x-axis. The first proof mass and second proof mass are configured to oscillate in anti-phase in a primary direction which is perpendicular to the y-axis.

The microelectromechanical device also comprises a first suspension structure which extends from a first anchor point to the first proof mass, and a second suspension structure which extends from a second anchor point to the second proof mass. The microelectromechanical device also comprises a first coupling structure, which is configured to transmit force in the primary direction between the first and second proof masses.

The first suspension structure may comprise a first y-axis spring structure which is more flexible in the y-direction than in the primary direction and a first primary spring structure which is more flexible in the primary direction than in the y-direction. The first y-axis spring structure may be connected between the first proof mass and the first primary spring structure. The first primary spring structure may be connected between the first y-axis spring structure and the first anchor point.

The first coupling structure is connected to the first primary spring structure in the first suspension structure. As explained in more detail below, the primary direction may be the x-direction, or it may be the z-direction.

Throughout this disclosure, the expression "spring structure A is more flexible in direction P1 than in direction P2" may alternatively be stated as "spring structure A is flexible in direction P1, and stiff in direction P2". In practice, the spring constant of spring structure A in direction P1 may for example be less than 10%, less than 25% or less than 50% of the spring constant of spring structure A in direction P2.

It may be noted that the term "suspension structure" refers in this disclosure to a larger structure where spring structure A is concatenated with another spring structure B, and this spring structure B may be stiff in direction P1 and flexible in direction P2. Consequently, the suspension structure as a whole may have (but does not necessarily have to have) substantially equal spring constants in the two directions P1 and P2, even though the spring constants in these two directions are unequal within spring structure A, and also unequal within spring structure B.

The second suspension structure may comprise a second y-axis spring structure which is more flexible in the y-direction than in the primary direction and a second primary spring structure which is more flexible in the primary direction than in the y-direction. The second y-axis spring structure may be connected between the second proof mass and the second primary spring structure, and the second primary spring structure may be connected between the second y-axis spring structure and the second anchor point. The first coupling structure may be connected to the second primary spring structure in the second suspension structure.

The first proof mass may optionally be coupled also to a third proof mass. In this case the device comprises a third proof mass, and the first proof mass and the third proof mass are in the device plane. The device may also comprise a third suspension structure which extends from a third anchor point to the third proof mass, a fourth suspension structure which extends from a fourth anchor point to the first proof mass, and a second coupling structure, which is configured to transmit force in the y-direction and extends from the third suspension structure to the fourth suspension structure.

The third suspension structure may comprise a third primary spring structure which is more flexible in the primary direction than in the y-direction and a third y-axis spring structure which is more flexible in the y-direction than in the primary direction, and the third primary spring structure may be connected between the third proof mass and the third y-axis spring structure, and the third y-axis spring structure may be connected between the third primary spring structure and the third anchor point.

The fourth suspension structure may comprise a fourth primary spring structure which is more flexible in the primary direction than in the y-direction and a fourth y-axis spring structure which is more flexible in the y-direction than in the primary direction. The fourth primary spring structure is connected between the first proof mass and the fourth y-axis spring structure, and the fourth y-axis spring structure may be connected between the fourth primary spring structure and the fourth anchor point.

The second coupling structure may be connected between the third y-axis spring structure and the fourth y-axis spring structure.

Any spring structure described in this disclosure may be a single spring. The single spring may be an elongated beam which is configured to be bent. The spring structure is in this case flexible in the direction in which the spring bends. An elongated beam which extends in the x-direction will bend flexibly in the y-direction or in the z-direction but be stiff in the x-direction. Conversely, an elongated beam which extends in the y-direction will bend flexibly in the x-direction or in the z-direction but be stiff in the y-direction.

However, the spring structures described in this disclosure do not have to consist of a single bending beam. They may alternatively be more complex arrangements which may include both flexible parts and rigid parts. The spring structures described in this disclosure may also be called decoupling structures, since these parts are intended to minimize cross-axis interference. In other words, the flexible properties of the spring structures are configured so that the first and second oscillation modes are independent of each other.

Spring structures which are flexible in the y-direction will be labelled "y-axis spring structures" throughout this disclosure. Spring structures which are flexible in the x-direction may be labelled either "primary spring structures" or "x-axis spring structures". Spring structures which are flexible in the z-direction may be labelled either "primary spring structures" or "z-axis spring structures".

Spring structures which are flexible in the y-direction may alternatively be labelled "laterally flexible spring structures", spring structures which are flexible in the x-direction may be labelled "transversally flexible spring structures", and spring structures which are flexible in the z-direction may be labelled "vertically flexible springs structures". The y-direction is in this case labelled the lateral direction, the x-direction is labelled the transversal direction, and the z-direction is labelled the vertical direction.

In any embodiment presented in this disclosure, the first and second proof masses may be made of silicon. The suspension structures and coupling structure may also be made of silicon. The proof masses, suspension structures and coupling structures may be formed in the device layer by etching the device layer.

### In-plane embodiment

In this embodiment, the primary direction is the x-direction defined by the x-axis. For reasons of clarity, this direction will be referred to as "the x-direction" or "the direction defined by the x-axis" when this embodiment is presented. In this embodiment, the primary spring structure may alternatively be called the "x-axis spring structure" since this spring structure is here flexible in the x-direction. The out-of-phase movement of the proof masses may in this embodiment comprise linear movement in the x-direction (in the first oscillation mode), and also linear movement in the y-direction (in the second oscillation mode), as figure 1a for example illustrates.

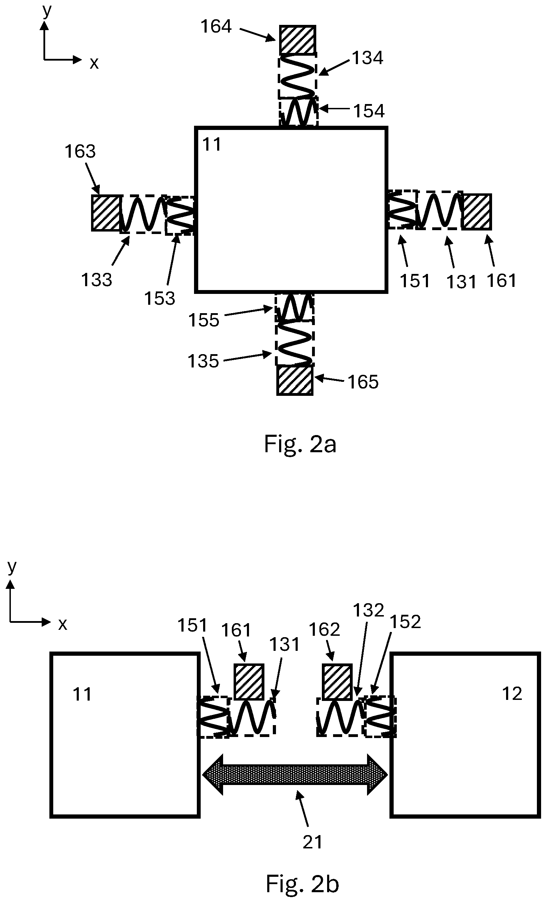

Figure 2a illustrates schematically a first proof mass 11 which is suspended from a fixed structure by a suspension structure. The fixed structure is illustrated by anchor points 161, 163, 164 and 165. The suspension structure comprises spring structures which are illustrated by spring symbols 151, 153, 154, 155 and 131, 133, 134 and 135. The direction of each spring symbol indicates its flexibility: spring structures 131, 133, 154 and 155 are flexible in the x-direction and stiff in the y-direction. Spring structures 134, 135, 151 and 153, on the other hand, are flexible in the y-direction and stiff in the x-direction. This illustration convention will be used throughout this disclosure.

In practice, the first suspension structure (to the right of the mass 11) comprises a first y-axis spring structure 151 which is more flexible in the y-direction than in the x-direction and a first primary spring structure 131 which is more flexible in the x-direction than in the y-direction.

The first y-axis spring structure 151 is connected between the first proof mass 11 and the first primary spring structure 131, and the first primary spring structure 131 is connected between the first y-axis spring structure 151 and the first anchor point 161. The suspension structure 133+153 on the opposite side of the first proof mass 11 comprises the corresponding parts.

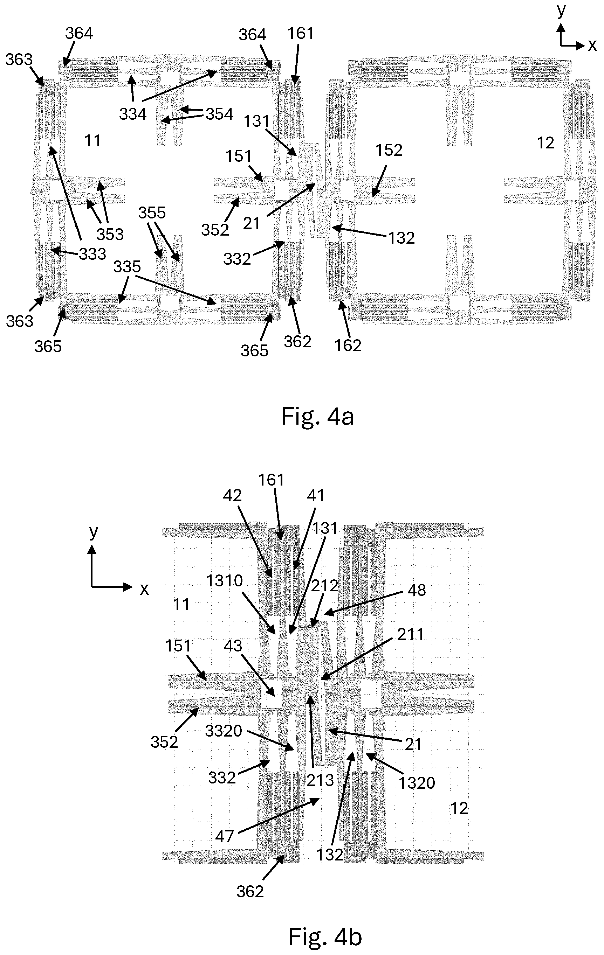

Throughout this disclosure, the suspension structures may comprise parts which are connected in series in a structure which extends from a proof mass and an anchor point. Part B is "connected between" parts A and C if it is located between A and C in this series. The series may A-B-C. But part B also is also connected between A and C if the series is for example A-B-D-C. In other words, the term "connected between A and C" also covers arrangements where the series contains optional additional parts (in this case, D). The intermediate part 43 in figure 4b is an example of an optional additional part in the suspension structure.

The first primary spring structure 131 provides the flexibility which is needed to accommodate the first oscillation mode which occurs in the x-direction, while the first y-axis spring structure 151 flexibly allows the second oscillation mode which occurs in the y-direction. When these two spring structures are connected in series, the suspension structure flexibly allows both oscillation modes. The suspension structure 133+153 on the opposite side of the first proof mass performs the same function.

Conversely, the suspension structures which are illustrated above and below the first proof mass 11 in figure 2a comprise a primary spring structure (154, 155) coupled in series with a y-axis spring structure (134, 135). The y-axis spring structures (134, 135) lie between the primary spring structures (154, 155) and the corresponding anchor points (164, 165). The suspension structures allow the proof mass to oscillate freely in both oscillation modes.

Drive transducers (not illustrated) which generate force in the x-direction may be connected directly to the first proof mass 11. Alternatively, drive transducers may be connected to the primary spring structures 131 and 133. Since these spring structures are stiff in the y-direction, the force generated by the drive transducers can be directed through the first primary spring structures precisely in the x-direction without any y-component being present, and the first proof mass can be driven in primary oscillation in the x-direction.

Sense transducers (not illustrated) which measure the movement of first proof mass 11 in the y-direction may be connected directly to the first proof mass 11. Alternatively, sense transducers may be connected to the y-axis spring structures 134 and 135. Since these spring structures are stiff in the x-direction, the only movement which takes place in these y-axis spring structures will be due to the momentum imparted by the first proof mass 11 oscillating in its secondary oscillation mode. The deformation of the y-axis spring structures in the y-direction may therefore be proportional to the displacement of the first proof mass 11 in the y-direction.

Figures 2b - 2d illustrate the first proof mass 11 and an adjacent second proof mass 12. Here the first suspension structure (131, 151) extends from the first anchor point (161) to the first proof mass (11), and the second suspension structure (132,152) extends from the second anchor point (162) to the second proof mass (12). The first coupling structure (21) is configured to transmit force in the x-direction between the first (11) and second (12) proof masses.

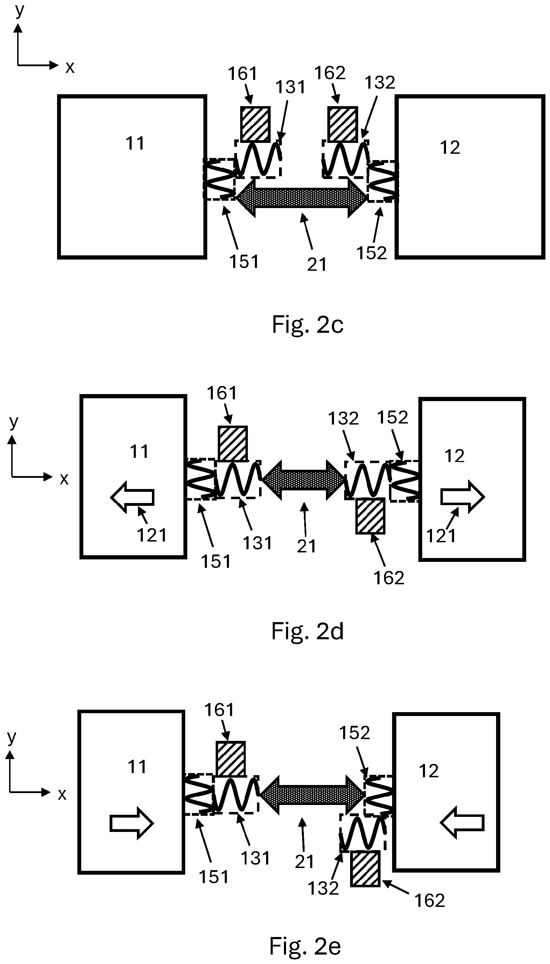

The first and second proof masses form a mass pair which is configured to undergo out-of-phase oscillation, back and forth in the direction of the x-axis. Out-of-phase oscillation may also be called anti-phase oscillation. This oscillation is illustrated by arrows 121 in figure 2d, which illustrate a moment where the first and second proof masses 11 and 12 move away from each other. After moving away from each other, the first and second proof masses will then move back toward each other (as figure 2e illustrates, with a different coupling arrangement), and then away from each other again. In other words, the first and second proof masses 11 and 12 always move in opposite x-directions when they undergo anti-phase oscillation in the direction of the x-axis. First and second proof masses 11 and 12 are configured to move in anti-phase in the figures of this disclosure even when no arrows illustrate the movement.

The first and second proof masses 11 and 12 may optionally be coupled to additional proof masses, such as masses 13 and 14 in figures 1a - 1b. Alternatively, they may form a single proof mass pair and not be coupled to any other proof masses.

The second proof mass 12 in figures 2b - 2d may be suspended from a second anchor point 162 by a second suspension structure. The second suspension structure may comprise a second y-axis spring structure 152 which is more flexible in the y-direction than in the x-direction and a second primary spring structure 132 which is more flexible in the x-direction than in the y-direction. The second y-axis spring structure 152 may be connected between the second proof mass 12 and the second primary spring structure 132. The second primary spring structure 132 may be connected between the second y-axis spring structure 152 and the second anchor point 162. The properties and function of spring structures 132 and 152 correspond to the properties that were described above for structures 131 and 151. The second proof mass could alternatively be suspended with some other kind of arrangement which simply facilitates proof mass movement in both the x- and y-directions.

Figures 2b - 2d illustrates a first coupling structure 21 which is connected between the first proof mass 11 and second proof mass 12. All coupling structures described in this disclosure are configured to synchronize the out-of-phase oscillation of a proof mass pair. In figures 2b - 2d, the out-of-phase oscillation of first and second proof masses 11 and 12 in the x-direction is synchronized. Any coupling structure described in this disclosure may alternatively be called a synchronization structure.

Any coupling structure described in this disclosure may function also as a suspension structure. Alternatively, any coupling structure may provide only synchronization without providing structural support. Any coupling structure described in this disclosure may comprise one or more flexible springs and/or one or more rigid levers, which together connect two proof masses to each other and transmit force between them.

Throughout this disclosure, the term "synchronize", and phrases such as "structure A synchronizes oscillation mode X", have the following meaning. Structure A constitutes a mechanical connection in a system of interconnected proof masses which should preferably oscillate in the desired mode X (for example out-of-phase), but preferably not in an undesired mode Y (in-phase). Structure A exhibits a beneficial combination of rigidity and flexibility, so that the presence of structure A improves the relationship between the resonance frequency F_{X} of mode X and the resonance frequency F_{Y} of mode Y in the system.

The presence of structure A may, for example, increase the ratio F_{Y} / F_{X} and/or the difference F_{Y} - F_{X}. The reference state against which this improvement is measured may in some cases be the same system of proof masses without structure A. Structure A is in this case needed only for synchronization. In other cases, when structure A is also needed for supporting the weight of the proof masses, the reference state against which the synchronization improvement is measured may be the same system of proof masses where A has been replaced with an alternative structure B which gives structural support but flexibly accommodates both mode X and mode Y.

Figure 2b illustrates an option where the first coupling structure 21 is connected directly between the first proof mass 11 and the second proof mass 12. In other words, the first coupling structure 21 extends from the first proof mass to the second proof mass but is not connected to either suspension structure. Figure 2c illustrates an alternative arrangement where the coupling structure is connected between the first y-axis spring structure 151 and the second y-axis spring structure 152. If the action of the first coupling structure 21 is not completely ideal, so that the force transferred by the first coupling structure 21 comprises either a force component in the y-direction or a torque acting in the xy-plane, then the action will generate undesired motion in the first and second proof masses. In figure 2b, the first coupling structure 21 imparts the force or torque directly to the first and second proof masses 11 and 12. In figure 2c, the first and second y-axis spring structures 151 and 152 are flexible in the y-direction. They will be therefore displaced by the force or torque, and they will transmit the force or torque to the corresponding proof mass 11 and 12.

Figure 2d illustrates an arrangement where the first coupling structure (21) is connected to the first x-axis spring structure (131) in the first suspension structure. The benefit of this arrangement is that the primary spring structure 131 is stiff in the y-direction. Consequently, even if the action of the first coupling structure 21 is not ideal in terms of the direction of force transfer, only forces acting in the x-direction will be transmitted to the first proof mass 11. Any force acting in the y-direction or torque acting in the xy-plane will be nullified in the primary spring structure 131, since one end of the primary spring structure 131 is anchored and the primary spring structure 131 does not flex in the y-direction.

In figure 2d the second suspension structure comprises a second y-axis spring structure (152) which is more flexible in the y-direction than in the x-direction and a second primary spring structure (132) which is more flexible in the x-direction than in the y-direction. The second y-axis spring structure (152) is connected between the second proof mass (12) and the second primary spring structure (132). The second primary spring structure (132) is connected between the second y-axis spring structure (152) and the second anchor point (162). The first coupling structure 21 is connected to the second primary spring structure (132) in the second suspension structure. The coupling on the right-hand side in the figure has the same benefits as the coupling on the left-hand side.

Figure 2e illustrates a device where the first coupling structure 21 is connected to the first primary spring structure 131 on the left side and connected to the second y-axis spring structure 152 on the right side. The coupling structure may extend from the first suspension structure (131,151) to the second suspension structure (132,152). Furthermore, as figures 2d and 2e show, the first proof mass 11 and second proof mass 12 may be at least partly aligned in the x-direction, so that there is a line parallel to the x-axis which crosses both the first (11) and the second (12) proof mass. But many other options are also possible.

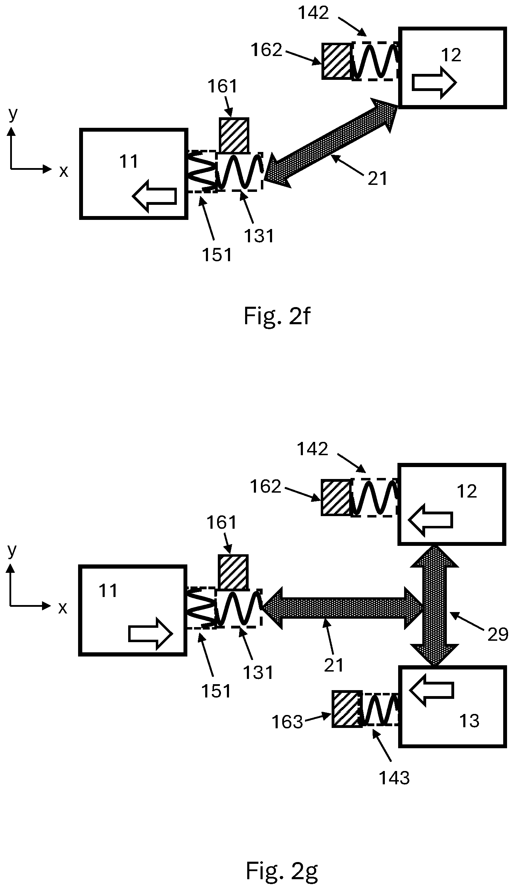

Figure 2f illustrates a device where the first proof mass 11 and second proof mass 12 are not aligned in the x-direction, and where the coupling structure extends directly to the second proof mass 12 but not to the second suspension structure 142. Figure 2g illustrates a more complex arrangement where the first proof mass 11 is coupled to two additional proof masses: the second proof mass 12 and a third proof mass 13 which is suspended from a third anchor point 163 by a third suspension structure 143. A second coupling structure 29 extends between the second proof mass 12 and third proof mass 13, and the first coupling structure 21 extends from the first suspension structure to this second coupling structure.

In short, the suspension and coupling arrangements which surround the second proof mass 12 on the right side of the first coupling structure 21 could include a variety of arrangements. The first coupling structure 21 does not necessarily have to be designed to avoid all force transfer in the y-direction. If the first coupling structure 21 attempts force transfer in the y-direction, the first primary spring structure 131 will nullify that force, as explained above. In practice, this means that coupling the first coupling structure 21 to the primary spring structure relaxes the design requirements placed on the first coupling structure 21. Even a non-ideal coupling structure, which may include some diagonal movement (possibly with x-, z- and y-components) and generation of torque in the device plane, can be used in some applications. These considerations apply also to the out-of-plane embodiment which will be presented below.

The remainder of this disclosure will focus on the two-sided embodiment shown in figure 2d, where the first coupling structure is coupled between the first primary spring structure 131 and the second primary spring structure 132.

The first oscillation mode, which comprises proof mass movement in the x-direction, may be induced by one or more force transducers, which may be called drive transducers. A drive voltage signal applied to a drive transducer may generate the driving force. Alternatively or additionally, proof mass movement in the first oscillation mode may be measured by one or more for transducers which may be called sense transducers. The movement of the proof mass may generate a sense voltage signal in the sense transducer.

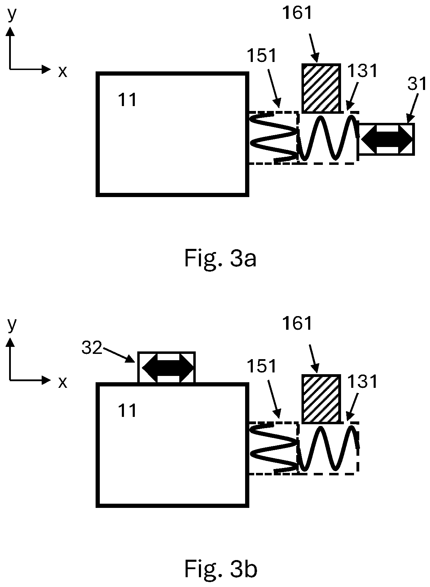

Figure 3a illustrates schematically an arrangement where a transducer 31 (which could be used as a drive transducer or a sense transducer) is structurally connected to the first primary spring structure 131. As explained in more detail below, a structural connection may in this disclosure mean that the entire transducer 31 is built on the first primary spring structure 131. Alternatively, it may mean that some parts of the transducer 31 are built on the first primary spring structure 131, and other parts of the same transducer 31 are built on a fixed structure (not illustrated in figure 3a) which is adjacent to the primary spring structure. Figure 3b illustrates another alternative where a transducer 32 is structurally connected to the first proof mass 11, without being connected to the suspension structure 131+151.

The transducers described in this disclosure may be capacitive transducers or piezoelectric transducers. The transducer 31 illustrated in figure 3a may for example be a piezoelectric transducer where conductive electrode layers and a piezoelectric layer are built on top of the first primary spring structure 131. The transducer 32 illustrated in figure 3b may for example be a capacitive transducer where the first proof mass 11 is used as one electrode of the capacitor, and the second electrode of the capacitor is formed on a fixed structure adjacent to the first proof mass 11. Other alternatives are also possible: the transducer 31 may alternatively be capacitive, and the transducer 32 may be piezoelectric. The transducer options presented above apply also to the out-of-plane embodiment presented below, with the only difference being that transducers 31 and 32 may in that embodiment be configured to generate or measure out-of-plane motion in the z-direction.

Any of the transducer options described above may be implemented with any of the arrangements illustrated in figures 2a - 2g. Force transducers may be built on each suspension structure described in this disclosure Each proof mass described in this disclosure may also be coupled to force transducers which generate or measure movement in the y-direction. Force transducers which act in the y-direction may be structurally connected to y-axis spring structures, such as 134 and 135 in figure 2a.

In other words, in this in-plane embodiment, the device may comprise one or more first drive transducers which are configured to set the first proof mass into linear drive oscillation in the direction of the x-axis. The one or more first drive transducers may be piezoelectric transducers located on the first primary spring structure. Alternatively, the one or more first drive transducers may be capacitive transducers connected to the first primary spring structure. A further option is that the one or more drive transduces may be connected directly to the first proof mass, as explained above.

In any embodiment described in this disclosure, including the out-of-plane embodiment, the device may comprise one or more first sense transducers which are configured to measure a sense oscillation induced by the Coriolis force in the first proof mass in the direction of the y-axis. The one or more first sense transducers may be piezoelectric transducers located on any y-axis spring structure described in this disclosure. Alternatively, the one or more first sense transducers may be capacitive transducers connected to any y-axis spring structure in this disclosure. A further option is that the one or more sense transduces may be connected directly to the first proof mass.

Figure 4a illustrates a device structure which corresponds to the schematic structure shown in figure 2d. Reference numbers 11, 12, 21, 131, 132, 151, 152, 161 and 162 have the same meaning in figure 4a as in the preceding figures. Reference numbers 333, 334, 335, 353, 354, 355, 363, 364 and 365 correspond to reference numbers 133, 134, 135, 153, 154, 155, 163, 164 and 165, respectively, in figure 2a.

The first and second proof masses 11 and 12 are in figure 4a suspended from eight different anchor points by eight suspension structures. These eight suspension structures comprise, on the left and rights sides of the first proof mass 11, additional y-axis spring structures (352, 353) and additional primary spring structures (332, 333). The additional y-axis spring structures (352, 353) are connected between the first proof mass (11) and the additional primary spring structure (332, 333). Each additional primary spring structure (332, 333) is connected between one of the additional y-axis spring structures (352, 353) and an additional anchor point (362, 363).

The eight suspension structures also comprise, on the top and bottom sides of the first proof mass 11, additional primary spring structures (354, 355) and additional y-axis spring structures (334, 335). The additional primary spring structures (354, 355) are connected between the first proof mass (11) and the additional y-axis spring structures (334, 335). Each additional y-axis spring structure (334, 335) is connected between one of the additional primary spring structures (354, 355) and an additional anchor point (364, 365).

All additional primary spring structures are more flexible in the x-direction than in the y-direction. All additional y-axis spring structures are more flexible in the y-direction than in the x-direction. The second proof mass 12 in this case has the same suspension arrangement as the first proof mass 11.

Figure 4a illustrates an alternative where each y-axis spring structure (151, 352, 353) which is directly attached to the first proof mass 11 has a high length / width aspect ratio, where length is measured in the x-direction and width in the y-direction. This aspect ratio may for example be greater than 10 or greater than 20. Correspondingly, the additional primary spring structures (354, 355) which are directly attached to the first proof mass 11 may have the same length / width aspect ratio, where length is measured in the y-direction and width in the x-direction.

In general, the first y-axis spring structure 151 may be a beam which extends in the x-direction from the first proof mass 11 toward the first primary spring structure 131. It may be attached directly to the first primary spring structure 131. Alternatively, as figure 4b illustrates, it may be attached to an intermediate part 43, and the first primary spring structure may be attached to the same intermediate part.

The primary spring structures (131, 332, 333) which are attached between y-axis spring structures (151, 352, 353) and anchor points (161, 362, 363) have a smaller length / width aspect ratio, where length is measured in the y-direction and width in the x-direction. The length / width aspect ratio of these spring structures may for example be greater than 5, or greater than 10.

The microelectromechanical device in figure 4a comprises piezoelectric force transducers on primary spring structures 131, 332 and 333) for generating or measuring motion in the x-direction. The device also comprises piezoelectric force transducers on y-axis spring structures 334 and 335 for generating or measuring motion in the y-direction.

Figure 4b illustrates the center of figure 4a in more detail. This device comprises two parallel primary spring structures (such as 131 and 1310) which extend in the y-direction from the same anchor point (161) to intermediate part 43. The intermediate part 43 is an optional intermediate structure which lies between the y-axis spring structures (151, 352) and the primary spring structures (131, 1310, 332, 3320, 132, 1320). All y-axis spring structures and primary spring structures on one side of the proof mass 11 may be connected to the same intermediate part 43, as figures 4a and 4b illustrate.

The other primary spring structures (332, 132) in the figures are also paired with extra spring structures (3320, 1320) and the same arrangement is applied on all sides of the first and second proof masses. The pairwise arrangement is optional - a single primary spring structure could also be used. The pairwise arrangement may in some applications help stabilize force transfer in the x-direction from the primary spring structures (131, 1310, 332, 3320, 132, 1320) to the intermediate part 43 because it can effectively prevent rotational movement in the intermediate part 43.

Figure 4b illustrates a piezoelectric force transducer (41, 42) on each primary spring structure. Each piezoelectric force transducer (41, 42) may be a drive transducer which is configured to generate force in the x-direction by bending the corresponding primary spring structure (131, 1310). Alternatively or additionally, each piezoelectric force transducer (41, 42) may be a sense transducer which is configured to measure the bending of the corresponding primary spring structure (131, 1310). Each piezoelectric force transducer (41, 42) may comprise two parallel strips of a piezoelectric material, illustrated as straight lines in figures 4a and 4b. These strips may be sandwiched between electrode layers (not illustrated) in the z-direction. Figure 4a illustrates that similar force transducers, configured to generate or measure movement in the y-direction, may be built also on y-axis spring structures 334 and 335.

The dimensional options and transducer options described above apply also to the out-of-plane embodiment, except that the drive transducers are in that embodiment configured to generate force in the z-direction by bending the corresponding primary spring structure out of the device plane.

In figures 4a and 4b the first coupling structure 21 comprises a lever 211 which is configured to rotate in the xy-plane when the first and second proof masses 11 and 12 oscillate in anti-phase in the x-direction. The first coupling structure 21 may also comprise support elements 213 which support the lever and extend from the lever 211 to adjacent fixed structures 47 and 48. These fixed structures do not undergo any movement. The first coupling structure 21 may also comprise joints 212 which connect the lever 211 to the first (131) and second (132) primary spring structures.

The lever 211 may rotate as a rigid body about an axis perpendicular to the xy-plane. In other words, when the device is operated and the proof masses oscillate, the lever 211 may transmit force between the proof masses without bending significantly. However, even if the ideal lever is stiff, it may still be beneficial in some practical applications to make the lever 211 so narrow that slight bending may occur in the lever during operation. The joints 212 and support elements which join the levers to fixed structures and to the proof masses may nevertheless be significantly more flexible than the lever, so that they can absorb the twisting forces which act in the coupling structure when the lever 211 turns in the device plane.

The lever may have an elongated shape, so that its length in a first dimension of the xy-plane is substantially greater than its width in a second dimension (perpendicular to the first) of the xy-plane. The length / width aspect ratio may for example be greater than 2:1, greater than 3:1 or greater than 4:1. This elongated shape typically minimizes the area covered by the coupling arrangement. However, the lever could alternatively have a shape which is not elongated and where the length / width aspect ratio is less than 2:1. The properties of the lever described in the previous two paragraphs apply also in the out-of-plane embodiment, except for the fact that the lever in that embodiment rotates about a rotation axis which lies in the xy-plane. The rotation axis is parallel to the x-axis.

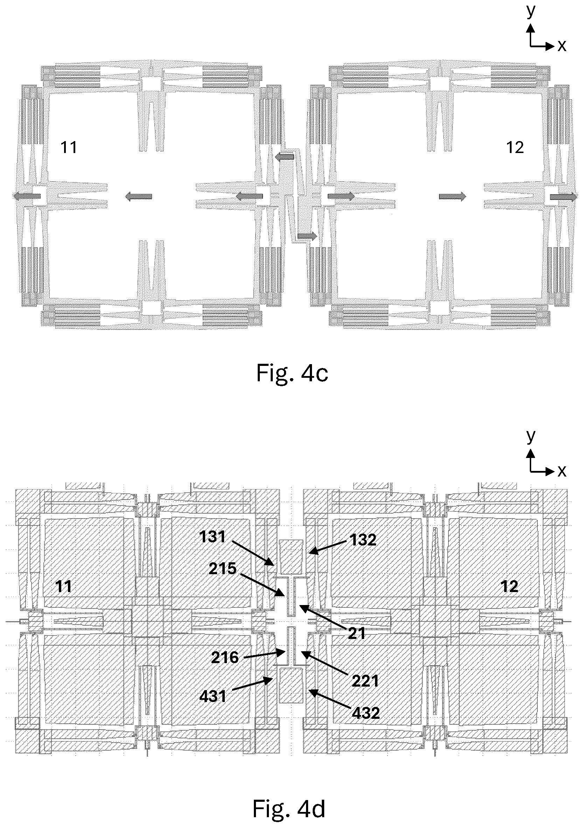

In general, the first coupling structure may comprise a lever which is configured to rotate in the device plane, and a first end of the lever may be attached to the first primary spring structure. Figure 4c illustrates with arrows the movement of the two ends of the lever 211 when the first proof mass 11 and second proof mass 12 oscillate in anti-phase in the x-direction.

Other suspension structures and coupling structures are also possible. Figure 4d illustrates a first coupling structure 21 which comprises a compressible spring 215 which expands and contracts in the x-direction when the first proof mass 11 and second proof mass 12 oscillate in anti-phase. An additional coupling structure 221, comprising an additional compressible spring 216, also extends between the primary spring structures 431 and 432.

The suspension, coupling and force-transfer arrangements that have been described above in one dimension (the x-direction) can be expanded to two dimensions (x and y) in devices with four proof masses, like the ones illustrated schematically in figures 1a and 1b.

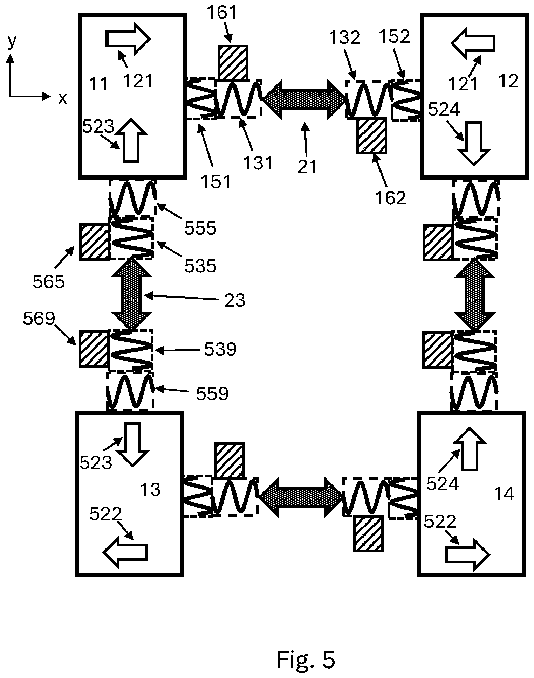

Figure 5 illustrates a device with four proof masses 11 - 14. All arrangements between the first proof mass 11 and the second proof mass 12 are the same as in figure 2d.

In addition, the device in figure 5 also comprises a third proof mass 13. The first proof mass 11 and the third proof mass 13 are in the device plane. The device also comprises a third suspension structure which extends from a third anchor point 569 to the third proof mass 13, and a fourth suspension structure which extends from a fourth anchor point 565 to the first proof mass 11.

A second coupling structure 23, which is configured to transmit force in the y-direction, extends from the third suspension structure to the fourth suspension structure. The third suspension structure comprises a third primary spring structure 559 which is more flexible in the x-direction than in the y-direction and a third y-axis spring structure 539 which is more flexible in the y-direction than in the x-direction. The third primary spring structure 559 is connected between the third proof mass 13 and the third y-axis spring structure 539. The third y-axis spring structure 539 is connected between the third primary spring structure 559 and the third anchor point 569.

The fourth suspension structure comprises a fourth primary spring structure 555 which is more flexible in the x-direction than in the y-direction and a fourth y-axis spring structure 535 which is more flexible in the y-direction than in the x-direction. The fourth primary spring structure 555 is connected between the first proof mass 11 and the fourth y-axis spring structure 535. The fourth y-axis spring structure 535 is connected between the fourth primary spring structure 555 and the fourth anchor point 565.

The second coupling structure 23 is connected between the third y-axis spring structure 539 and the fourth y-axis spring structure 535.

The anti-phase movement 121 in figure 5 is the same as in figure 2d, and the third (13) and fourth (14) proof masses are also configured to undergo linear anti-phase oscillation 522 in the opposite phase. In other words, when the pair 11+12 moves away from each in the x-direction, the pair 13+14 moves toward each other in the x-direction, as figure 5 illustrates. This may be the first oscillation mode of the illustrated device.

Furthermore, the first and third proof masses 11 and 13 may be configured to undergo anti-phase oscillation 523 in the y-direction. The second (12) and fourth (14) proof masses may also be configured to undergo linear anti-phase oscillation 524 in the opposite phase. In other words, when the pair 11+13 moves away from each in the y-direction, the pair 12+14 moves toward each other in the y-direction, as figure 5 illustrates. This may be the second oscillation mode of the illustrated device.

The second coupling structure 23 may be configured to synchronize the second oscillation mode in the same manner that the first coupling structure 21 synchronizes the first oscillation mode. All detailed options presented above for the first coupling structure 21 and the suspensions to which the first coupling structure is linked apply also to the second coupling structure 23 and the suspensions to which the second coupling structure is linked. Furthermore, as figure 5 illustrates, the device may comprise additional coupling structures between mass pairs 13+14 and 12+14 which operate in the same manner as the first (21) and second (22) coupling structures.

Many other options are also possible. For example, the first proof mass may be connected to the second and third proof masses, but neither of these may be connected to a fourth proof mass. Any of the arrangements shown in figures 2e - 2g could be implemented also in the y-direction.

### Out-of-plane embodiment

In this embodiment the primary direction is a z-direction defined by a z-axis which is perpendicular to both the x-axis and the y-axis. For reasons of clarity, this direction will be referred to as "the z-direction" or "the direction defined by the z-axis" when this embodiment is presented. In this embodiment, the primary spring structure may alternatively be called the "z-axis spring structure" since this spring structure is here flexible in the z-direction.

The out-of-phase movement of the proof masses in the z-direction may in this embodiment comprise linear movement in the z-direction (in the first oscillation mode) and linear movement in the y-direction (in the second oscillation mode).

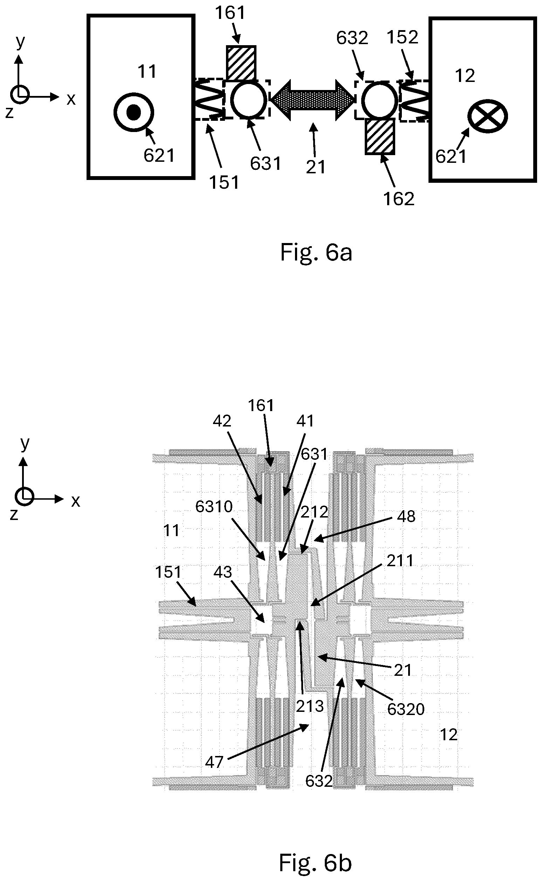

Figure 6a illustrates schematically a first proof mass 11 which is suspended from a fixed structure by a suspension structure. The fixed structure is illustrated by anchor points 161, and 162. The suspension structure comprises spring structures which are illustrated by symbols 151, 152, 631 and 632.

The discussion about y-axis springs structures 151 and 152 in the in-plane embodiment above applies also to this out-of-plane embodiment, with the additional remark that all y-axis spring structures are in this embodiment stiff in the z-direction, which is the primary direction in this embodiment. They will therefore rigidly transmit force in the z-direction.

Symbols 631 and 632 indicate flexibility in the z-direction. Spring structures 631 and 632 are therefore flexible in the z-direction and stiff in the y-direction. They may, but do not necessarily have to, also be flexible in the x-direction.

The first and second proof masses form a mass pair which is configured to undergo out-of-phase oscillation, back and forth in the direction of the z-axis. The first and second proof masses 11 and 12 always move in opposite z-directions when they undergo anti-phase oscillation in the direction of the z-axis. Out-of-phase oscillation may also be called anti-phase oscillation.

The symbols 621 indicate the anti-phase out-of-plane movement of proof masses 11 and 12. The symbol 621 on the right indicates movement away from the viewer, while the symbol 621 on the right illustrates movement toward the viewer. In the opposite phase of the oscillation cycle, proof mass 11 would instead move toward the viewer and proof mass 12 would move away from the viewer.

The first primary spring structure 631 provides the flexibility which is needed to accommodate a first oscillation mode which occurs in the z-direction, while the first y-axis spring structure 151 flexibly allows the second oscillation mode which occurs in the y-direction. When these two spring structures are connected in series, the suspension structure flexibly allows both oscillation modes. The suspension structure 152+632 performs the same function at the second proof mass 12.

Here the first suspension structure (151, 631) extends from the first anchor point (161) to the first proof mass (11), and the second suspension structure (152, 632) extends from the second anchor point (162) to the second proof mass (12). The first coupling structure (21) is configured to transmit force in the z-direction between the first (11) and second (12) proof masses.

As in the in-plane embodiment, the first and second proof masses 11 and 12 may optionally be coupled to additional proof masses, such as masses 13 and 14 in figures 1a - 1b (although the first oscillation mode illustrated in figure 1a would in this out-of-plane embodiment instead comprise out-of-plane anti-phase movement). The options described in the in-plane embodiment concerning three or more masses apply to this embodiment as well, the only difference being that the first oscillation now comprises movement mainly in the z-direction instead of movement in the x-direction.

More complicated coupling options, such as the ones illustrated in figures 2f - 2g, are also possible in the out-of-plane embodiment, again the only difference being that the first oscillation now comprises movement mainly in the z-direction instead of movement in the x-direction. Furthermore, alternative coupling options analogous to the one shown in figure 2e are also possible in this out-of-plane embodiment. The following presentation of the out-of-plane embodiment will nevertheless focus primarily on the single proof mass pair illustrated in figure 6a (which may or may not be coupled to other proof masses).

Figure 6a illustrates an arrangement where the first coupling structure (21) is connected to the first primary spring structure (631) in the first suspension structure. The benefit of this arrangement is that the primary spring structure 631 is stiff in the y-direction. Consequently, even if the action of the first coupling structure 21 is not ideal in terms of the direction of force transfer, only forces acting in the z-direction will be transmitted to the first proof mass 11. Any force acting in the y-direction or torque acting in the xy-plane or yz-plane will be nullified in the primary spring structure 631, since one end of the primary spring structure 631 is anchored and the primary spring structure 631 does not flex in the y-direction.

In figure 6a the second suspension structure comprises a second y-axis spring structure (152) which is more flexible in the y-direction than in the x-direction and a second primary spring structure (632) which is more flexible in the z-direction than in the y-direction. The second y-axis spring structure (152) is connected between the second proof mass (12) and the second primary spring structure (632). The second primary spring structure (632) is connected between the second y-axis spring structure (152) and the second anchor point (162). The first coupling structure 21 is connected to the second primary spring structure (632) in the second suspension structure. The coupling on the right-hand side in the figure has the same benefits as the coupling on the left-hand side.

In this out-of-plane embodiment, the device may comprise one or more first drive transducers which are configured to set the first proof mass into linear drive oscillation in the direction of the z-axis. The one or more first drive transducers may be piezoelectric transducers located on the first primary spring structure. Alternatively, the one or more first drive transducers may be capacitive transducers connected to the first primary spring structure. A further option is that the one or more drive transduces may be connected directly to the first proof mass, as explained above.

The device structure may in this out-of-plane embodiment be very similar to the device structure illustrated in figure 4a. The main difference is that all primary spring structures are flexible in the z-direction in this embodiment. Figure 6b illustrates the center of the device in more detail. Reference numbers 41, 42, 47, 48, 211, 212 and 213 refer to the same elements in figure 6b as in figure 4b, but the piezoelectric force transducers 41 and 42 may in this case be configured to generate force in the z-direction, so that the beams where these transducers are located bend out of the device plane. Figure 6b shows two parallel strips of piezoelectric material on each primary spring structure (631, 6310). A single, wider strip could alternatively be used on each primary spring structure.

In other words, each piezoelectric force transducer (41, 42) may be a drive transducer which is configured to generate force in the z-direction by bending the corresponding primary spring structure (631, 6310). Alternatively or additionally, each piezoelectric force transducer (41, 42) may be a sense transducer which is configured to measure the bending of the corresponding primary spring structure (631, 6310). Each piezoelectric force transducer (41, 42) may comprise a strip of a piezoelectric material sandwiched between electrode layers (not illustrated) in the z-direction. As in figure 4a, similar force transducers, configured to generate or measure movement in the y-direction, may in this out-of-plane embodiment be built on y-axis spring structures such as 334 and 335 in figure 4a.

Reference numbers 6310 and 6320 illustrate optional additional primary spring structures in figure 6b. They produce the same benefit as the additional primary spring structures 1310 and 1320 in figure 4b.

The first and second proof masses 11 and 12 in figure 6a may be configured to undergo linear anti-phase oscillation in the y-direction in the second oscillation mode. The first and second y-axis spring structures 151 and 152 flexibly accommodate this oscillation mode.

The first coupling structure in figure 6b comprises a lever 211 which is configured to rotate out of the device plane. A first end of the lever 211 is attached to the first primary spring structure 631. The lever support elements 213 allow the lever 211 to rotate about an axis which lies in the device plane and is parallel to the x-axis, so that the first end of the lever 211 moves in one out-of-plane direction when the second end of the lever 211 moves in the other, opposite out-of-plane direction.

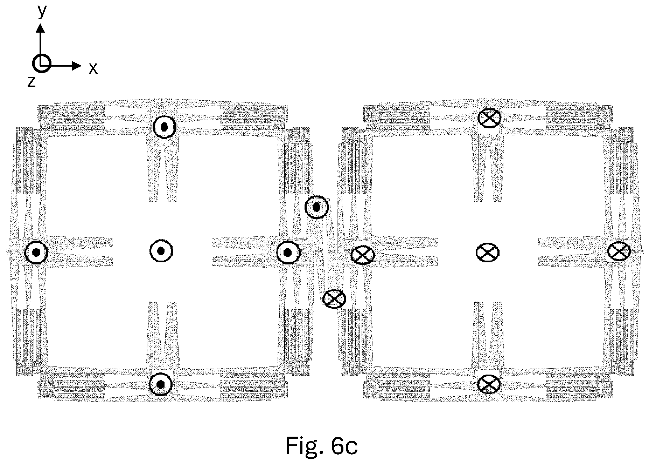

Figure 6c illustrates the out-of-plane movement of some parts of the coupling and suspension structures shown in figure 6b in the first oscillation mode. Each movement is reversed in the opposite phase of the oscillation cycle.

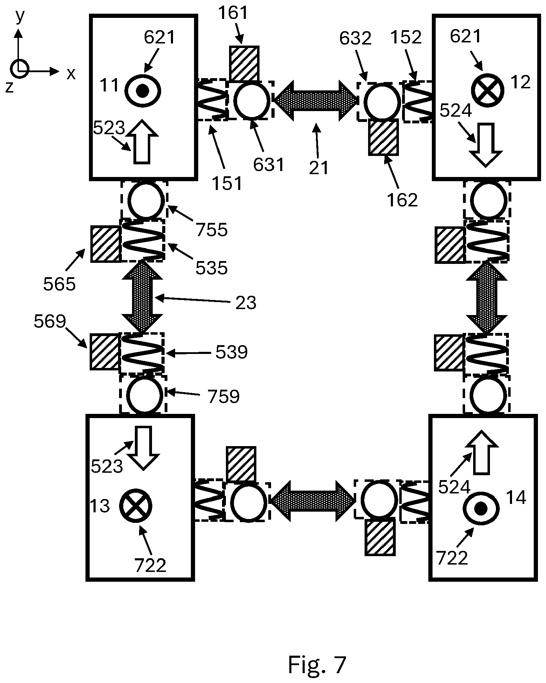

The coupling and force-transfer arrangements in the z-direction that have been described above can be utilized also in devices with four proof masses. This is illustrated in figure 7, where reference numbers 621 and 722 indicate out-of-plane movement, and reference numbers 755 and 759 indicate additional primary spring structures which are flexible in the out-of-plane direction and accommodate the first oscillation mode.

More precisely, figure 7 shows a device which comprises a third proof mass 13. The first proof mass 11 and the third proof mass 13 are in the device plane. The device also comprises a third suspension structure which extends from a third anchor point 569 to the third proof mass 13, and a fourth suspension structure which extends from a fourth anchor point 565 to the first proof mass 11.

A second coupling structure 23, which is configured to transmit force in the y-direction, extends from the third suspension structure to the fourth suspension structure. This coupling structure may for example be the kind of coupling structure which was presented in the in-plane embodiment above. The third suspension structure comprises a third primary spring structure 759 which is more flexible in the z-direction than in the y-direction and a third y-axis spring structure 539 which is more flexible in the y-direction than in the z-direction. The third primary spring structure 759 is connected between the third proof mass 13 and the third y-axis spring structure 539. The third y-axis spring structure 539 is connected between the third primary spring structure 759 and the third anchor point 569.

The fourth suspension structure comprises a fourth primary spring structure 755 which is more flexible in the z-direction than in the y-direction and a fourth y-axis spring structure 535 which is more flexible in the y-direction than in the z-direction. The fourth primary spring structure 755 is connected between the first proof mass 11 and the fourth y-axis spring structure 535. The fourth y-axis spring structure 535 is connected between the fourth primary spring structure 755 and the fourth anchor point 565.

The second coupling structure 23 is connected between the third y-axis spring structure 539 and the fourth y-axis spring structure 535.

The out-of-plane anti-phase movement 621 in the first oscillation mode in figure 7 is the same as in figure 6a. The third (13) and fourth (14) proof masses are also configured to undergo out-of-plane anti-phase oscillation 722 in the opposite phase. The third and fourth primary spring structures 759 and 755 are configured to flexibly accommodate this movement.

The first and third proof masses 11 and 13 are also configured to undergo linear anti-phase oscillation 523 in the y-direction in the second oscillation mode. The second (12) and fourth (14) proof masses may also be configured to undergo similar linear anti-phase oscillation 524 in the opposite phase.

The second coupling structure 23 may be configured to synchronize the second oscillation mode. The second coupling structure is coupled between y-axis spring structures 535 and 539 which are stiff in the z-direction. Consequently, as explained in the in-plane embodiment above, even if the action of the second coupling structure is not perfectly ideal, the out-of-plane oscillation of the proof masses 11 and 13 will not interfere with the force transfer which occurs through the second coupling structure 23. No cross-axis signal will then be introduced to the sense signal measured from the first and third proof masses.

All detailed options presented for the first coupling structure 21 in the in-plane embodiment apply also to the second coupling structure 23 in figure 7. Furthermore, as figure 7 illustrates, the device may comprise additional coupling structures between mass pairs 13+14 and 12+14 which operate in the same manner as the first (21) and second (22) coupling structures.

The device structure introduced in figure 4a could, with minor modifications, also be used in the configuration which is shown schematically in figure 7. These modifications may for example include changing the fully straight shape of springs structures 354 and 355 (shown in figure 4a) into a shape which comprises one or more orthogonal turns in the xy-plane to give these structures flexibility in the y-direction. Spring structures 335 could also be made thinner in the y-direction to increase the difference between their flexibility in the y-direction and their flexibility in the z-direction. These options have not been illustrated.

Many other options are also possible. For example, the first proof mass may be connected to the second and third proof masses, but neither of these may be connected to a fourth proof mass. Any of the arrangements shown in figures 2e - 2g could also be implemented in the y-direction.

## Claims

1. A microelectromechanical device which comprises:
- a first proof mass and a second proof mass in a device plane, wherein the device plane is defined by an x-axis and a y-axis which is perpendicular to the x-axis, and the first proof mass and second proof mass are configured to oscillate in anti-phase in a primary direction which is perpendicular to the y-axis,
- a first suspension structure which extends from a first anchor point to the first proof mass,
- a second suspension structure which extends from a second anchor point to the second proof mass, and
- a first coupling structure, which is configured to transmit force in the primary direction between the first and second proof masses,
**characterized in that**
- the first suspension structure comprises a first y-axis spring structure which is more flexible in the y-direction than in the primary direction and a first primary spring structure which is more flexible in the primary direction than in the y-direction, and the first y-axis spring structure is connected between the first proof mass and the first primary spring structure, and the first primary spring structure is connected between the first y-axis spring structure and the first anchor point,
- the first coupling structure is connected to the first primary spring structure in the first suspension structure.

2. A microelectromechanical device according to claim 1, wherein the second suspension structure comprises a second y-axis spring structure which is more flexible in the y-direction than in the primary direction and a second primary spring structure which is more flexible in the primary direction than in the y-direction, and the second y-axis spring structure is connected between the second proof mass and the second primary spring structure, and the second primary spring structure is connected between the second y-axis spring structure and the second anchor point, and the first coupling structure is connected to the second primary spring structure in the second suspension structure.

3. A microelectromechanical device according to any of claims 1-2, wherein the primary direction is the x-direction defined by the x-axis.

4. A microelectromechanical device according to claim 3, wherein the first coupling structure comprises a lever which is configured to rotate in the device plane, and a first end of the lever is attached to the first primary spring structure.

5. A microelectromechanical device according to any of claims 1-2, wherein the primary direction is a z-direction defined by a z-axis which is perpendicular to both the x-axis and the y-axis.

6. A microelectromechanical device according to claim 5, wherein the first coupling structure comprises a lever which is configured to rotate out of the device plane, and a first end of the lever is attached to the first primary spring structure.

7. A microelectromechanical device according to any preceding claim, wherein the first y-axis spring structure is a beam which extends in the x-direction from the first proof mass toward the first primary spring structure.

8. A microelectromechanical device according to any preceding claim, wherein the device comprises one or more first drive transducers which are configured to set the first proof mass into drive oscillation in the primary direction.

9. A microelectromechanical device according to claim 8, wherein the one or more first drive transducers are piezoelectric transducers located on the first primary spring structure.

10. A microelectromechanical device according to claim 8, wherein the one or more first drive transducers are capacitive transducers connected to the first primary spring structure.

11. A microelectromechanical device according to any preceding claim, wherein the device comprises one or more first sense transducers which are configured to measure a sense oscillation induced by the Coriolis force in the first proof mass in the direction of the y-axis.

12. A microelectromechanical device according to any preceding claim, wherein the first and second proof masses are made of silicon.

13. A microelectromechanical device according to any preceding claim, wherein the device also comprises a third proof mass, and the first proof mass and the third proof mass are in the device plane, and the device also comprises
- a third suspension structure which extends from a third anchor point to the third proof mass,
- a fourth suspension structure which extends from a fourth anchor point to the first proof mass, and
- a second coupling structure, which is configured to transmit force in the y-direction, extends from the third suspension structure to the fourth suspension structure,
- and the third suspension structure comprises a third primary spring structure which is more flexible in the primary direction than in the y-direction and a third y-axis spring structure which is more flexible in the y-direction than in the primary direction, and the third primary spring structure is connected between the third proof mass and the third y-axis spring structure, and the third y-axis spring structure is connected between the third primary spring structure and the third anchor point,
- and the fourth suspension structure comprises a fourth primary spring structure which is more flexible in the primary direction than in the y-direction and a fourth y-axis spring structure which is more flexible in the y-direction than in the primary direction, and the fourth primary spring structure is connected between the first proof mass and the fourth y-axis spring structure, and the fourth y-axis spring structure is connected between the fourth primary spring structure and the fourth anchor point, and
- and the second coupling structure is connected between the third y-axis spring structure and the fourth y-axis spring structure.

14. A microelectromechanical device according to any preceding claim, wherein the device is a gyroscope.

15. A microelectromechanical device according to any of claims 1-13, wherein the device is a resonator.
